# EUROPEAN PATENT SPECIFICATION

(11) **EP 1 649 994 B1**
(45) Date of publication and mention of the grant of the patent: **25.07.2012**
(21) Application number: 05256451.5
(22) Date of filing: 18.10.2005
(51) Int. Cl.: B28B 3/26, B28B 3/20, C23C 16/26

(54) **Die and method for extrusion forming of ceramics**
Mundstück und Verfahren zum Extrudieren keramischer Masse
Filière et méthode pour extruder des matières céramiques

(30) Priority: 21.10.2004 JP 2004307169
(43) Date of publication of application: 26.04.2006
(73) Proprietor: NGK Insulators, Ltd., Nagoya-city, Aichi 467-8530 (JP)
(72) Inventor: Matsuoka, Susumu, NGK Insulators, Ltd., Nagoya City Aichi-ken 467-8530 (JP); Ito, Kenichi, NGK Insulators, Ltd., Nagoya City Aichi-ken 467-8530 (JP); Mori, Teruyoshi, NGK Insulators, Ltd., Nagoya City Aichi-ken 467-8530 (JP); Saito, Takao, NGK Insulators, Ltd., Nagoya City Aichi-ken 467-8530 (JP); Shichi, Masayuki, Nagoya City, Aichi-Ken, 467-8530 (JP)
(74) Representative: Paget, Hugh Charles Edward

(56) References cited:
- US-A1- 4 364 888
- US-A1- 5 997 720
- US-A1- 2002 172 765
- US-B1- 6 299 813

## Description

### BACKGROUND OF THE INVENTION

Field of the Invention

The present invention relates to a die for extrusion forming of ceramics suitably used for extrusion forming of a ceramic honeycomb structure and the like, and, more particularly, to a die for extrusion forming of ceramics which can remarkably reduce defective formed bodies due to molding failure in the periphery of a ceramic formed body, while exhibiting excellent abrasion resistance.

Description of Related Art

A catalyst carrier for removing air pollutants in exhaust gas discharged from combustion engines, boilers, and the like and a filter for collecting diesel fine particles are mainly made up of a ceramic honeycomb structure.

As the die for extrusion forming of honeycomb structure, a die provided with a die member in which groove-like slits are formed by means of a cell block on the surface of a matrix such as stainless steel or SKD and having holes provided on the opposite side of the slits and communicating with the slits has been conventionally known.

In such a die for forming honeycomb structure, after forming a nickel plated layer on the surface of the cell block main body, for example, a CVD or PVD layer containing one or more of TiC, TiN, and TiCN, or a complex plated layer of a nickel plated film in which a hard powder of SiC, diamond, CBN, or the like is dispersed is formed on the surface of the nickel plated layer, in order to adjust a slit width of the cell blocks and to increase durability of the dies (see, for example, Japanese Patent Application Laid-open No. 1995-52129).

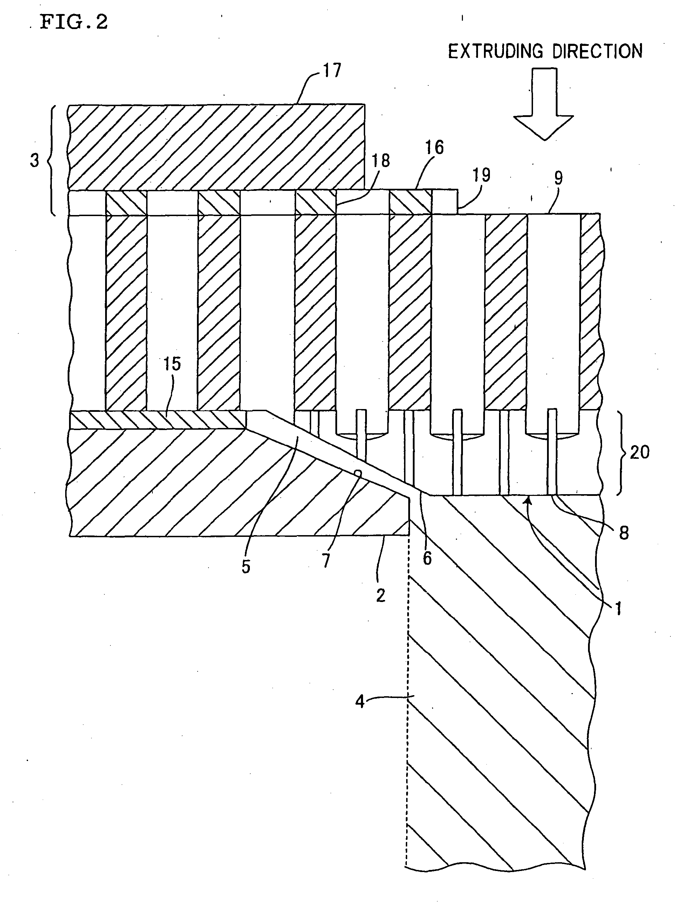

The Japanese Patent Application Laid-open No. 1995-52129 discloses a die used for extrusion forming of ceramic honeycombs shown in Figure 2, in which ceramic clay is extruded downwardly and a back press board 3 is provided to adjust the amount of the clay discharged to the die. A die member 1 is secured to a press board 2. The clay extruded from slits between the die member 1 and the press board 2 adjusts and forms the periphery of the ceramic formed body 4.

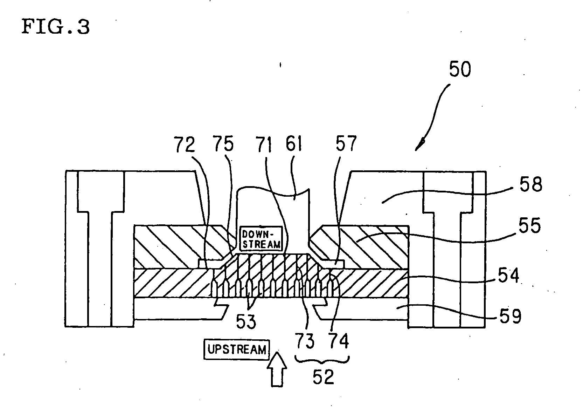

Japanese Patent Application Laid-open No. 2002-283327 discloses an apparatus for forming a honeycomb structure shown in Figure 3. Figure 3 shows a vertical cross-sectional view of an apparatus 50 for forming a honeycomb structure having holes 53 for introducing a raw material to be formed, a die member 54 having slits 52 for extruding the raw material, and a press board 55 provided in the downstream of the die member 54. A honeycomb structure 61 can be produced by continuously extruding the raw material using this apparatus.

In this apparatus 50, the die member 54 consists of an inner section 71 and a periphery section 72. The inner section 71 projects toward the downstream side forming a step section 75 with the periphery section 72. The inner section is provided with slits 73 for forming a honeycomb structure and the periphery section 72 is provided with slits 74 which are shorter than the slits 73. A space section 57 for forming the outer wall of the honeycomb structure is provided between the die member 54 and the press board 55. A press member 58 and a back press board 59 are holders for setting the die member 54 and the press board 55.

As shown in Figure 3, in extrusion forming using the honeycomb structure forming apparatus 50, the raw material is extruded via the die member 54 to the downstream side of the die member 54 from the upstream side by an extruder (not shown). The raw material extruded from the slits 73 provided in the inner section 71 of the die member 54, which open to the down-stream side, forms a honeycomb structure consisting of a number of cells. On the other hand, the honeycomb configuration of the raw material extruded from the slits 74 in the periphery 72 of the die member 54 is destroyed by the action of the space section 57 as shown in Figure 3. The raw material changes its direction from the extruded direction to the direction of the step section 75 and, at the opening of the press board 55, again changes its direction to the extrusion direction, whereby the outer wall surrounding the cells is formed.

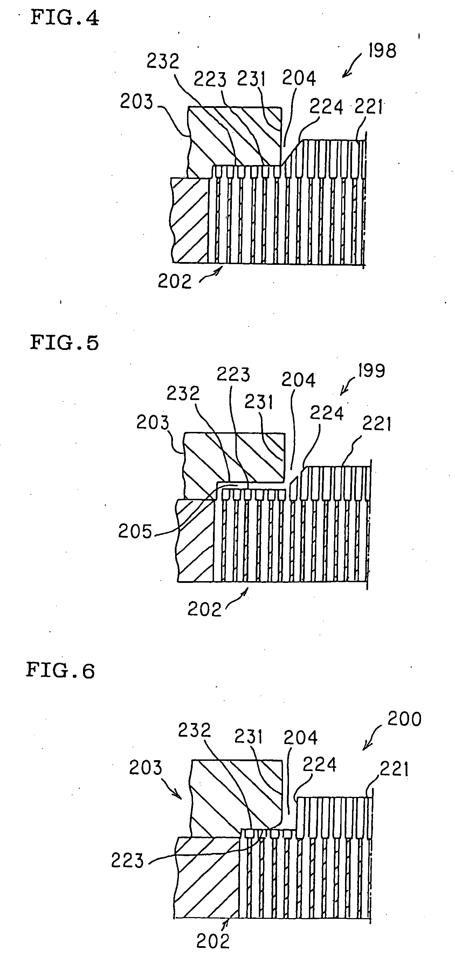

Figures 4-6 are cross-sectional diagrams of an example of the dies for forming the honeycomb structure disclosed in the patent application. A die member 202 for forming the honeycomb structure comprises a step section 223 formed around the entire circumference by cutting the periphery of the raw material outlet end of the die member 202, a step section 224 formed between the central part and the periphery of the raw material outlet end of the die member 202, and an annular space 204 formed between the step section 224 and an inner surface 231 of a die mask 203 (a press board), which is provided surrounding the step section 224 opposing thereto.

In a die member 198 for forming a honeycomb structure having the tapered step section 224 shown in Figure 4, the raw material flowing from the periphery of the die member 202 toward the center is extruded after having been sent to central forming grooves (slits) 221 of the die member 202 by pressure. Therefore, no pressure is applied to the area near the peripheral wall (outer wall) of the already formed honeycomb body, thereby preventing distortions in the partition near the peripheral wall of the resulting formed honeycomb body. The raw material filled into the space 204 joins the raw material which goes straight from the forming grooves 221 in the lower part and is extruded along the inner surface 231 of the die mask 203, thereby forming a thick and dense peripheral wall around the resulting formed honeycomb bodies. The patent specification describes that, for that reason, the formed honeycomb body with a high strength can be obtained.

In a honeycomb forming die member 199 provided with a space 205 between an end 232 of the die mask 203 and a step section 223 of the die member 202 opposing thereto, as shown in Figure 5, the density of the raw material sent by pressure from the forming grooves 221 of the step section 223 and the space 205 to the central forming grooves 221 and the space 204 is lower than the case of the honeycomb forming die member 198. The patent specification describes that the density of the raw material of the partition of through-holes (cells) and the peripheral wall therefore becomes uniform, whereby the thermal shock resistance can be improved. The specification further describes that if the step section 223 is not tapered, but parallel with the inner surface 231 of the die mask 203 as shown in Figure 6, a honeycomb forming die member 200 provided with the space 204 between these opposing sides can exhibit the same effect as the honeycomb forming die member 198.

A die for extrusion forming of aluminum in which a diamond-like carbon film (DLC film) is coated to a bearing side of the aluminum extrusion die after mirror finishing of the bearing side by polishing to ensure excellent formability of extruded aluminum for a long period of time has been known (for example, Japanese Patent Application Laid-open No. 2000-5811).

A die for extrusion forming of a resin film in which striated patterns on the formed resin film can be prevented by forming a DLC film for improving wear resistance and releasability of the resin has been known (for example, Japanese Patent Application Laid-open No. 2000-334806). In this example, the base material of the die is also processed by mirror plane polishing when forming a DLC film.

As mentioned above, in some conventional dies for extrusion forming, the area in contact with the raw material to be extruded from a die is polished by mirror plane finishing or coated with a DLC film after the mirror plane finishing in order to consistently obtain high quality formed bodies for a comparatively long period of time.

However, the extrusion forming of a ceramic formed body using a die for ceramic extrusion forming coated with DLC after mirror plane finishing as mentioned above has frequently encountered molding failures such as cutting or hangnail damages of the ceramic clay on the outer periphery of the ceramic formed bodies.

### SUMMARY OF THE INVENTION

The present invention has been achieved in view of the above-described problems in the prior art technologies. An object of the present invention is to provide a die suitably used for extrusion forming of ceramics and the like, particularly, a die for extrusion forming of ceramics which can remarkably reduce forming failures such as cutting or hangnail damages which frequently occur in the outer periphery of the ceramic formed bodies.

Specifically, the present invention provides a die for extrusion forming of ceramics for forming ceramic formed bodies, as set out in claim 1. The die may have a back press board which controls the amount of clay for a ceramic formed body arranged in the outer periphery of the die member, the surface roughness (Ra) of the part of the back press board coming in contact with extruded ceramic clay being 0.1 µm or more.

In the die for extrusion forming of ceramics of the present invention, the part of the press board coming in contact with extruded ceramic clay is coated with a diamond-like carbon (DLC) film from the viewpoint of durability and the surface of the die for extrusion forming of ceramics of the present invention may be prepared by coating a diamond-like carbon (DLC) film after roughening treatment of the surface to produce the surface roughness (Ra) of 0.1 µm or more.

The die for extrusion forming of ceramics of the present invention is suitably used for extrusion forming of a ceramic honeycomb structure as set out in claim 3.

The die for extrusion forming of ceramics of the present invention can exhibits a remarkable effect of reducing forming failures such as cutting or hangnail damages of the ceramic clay on the outer periphery of the extrusion-formed bodies.

### BRIEF DESCRIPTION OF THE DRAWINGS

Figure 1 is a schematic cross-sectional view showing an embodiment of a die for extrusion forming of honeycomb ceramic formed bodies.

Figure 2 is a schematic cross-sectional view showing another embodiment of a die for extrusion forming of honeycomb ceramic formed bodies.

Figure 3 is a schematic cross-sectional view showing still another embodiment of a die for extrusion forming of honeycomb ceramic formed bodies.

Figure 4 is a schematic cross-sectional view showing still another embodiment of a die for extrusion forming of honeycomb ceramic formed bodies.

Figure 5 is a schematic cross-sectional view showing still another embodiment of a die for extrusion forming of honeycomb ceramic formed bodies.

Figure 6 is a schematic cross-sectional view showing still another embodiment of a die for extrusion forming of honeycomb ceramic formed bodies.

Figure 7 is a schematic cross-sectional view for illustrating the surface conditions of part of a press board used in Test Example 1, wherein Figure 7(a) shows the entire view and Figure 7(b) is an enlarged illustration of the part X of Figure 7(a).

Figure 8 is a schematic cross-sectional view for illustrating the surface conditions of part of the press board used in Test Examples 2-10, wherein Figure 8(a) shows the entire view and Figure 8(b) is an enlarged illustration of the part Y of Figure 8(a).

Figure 9 is a schematic cross-sectional view for illustrating the surface conditions of part of the press board used in Comparative Example (Test Example 11), wherein Figure 9(a) shows the entire view and Figure 9(b) is an enlarged illustration of the part Z of Figure 9(a).

Figure 10 is a surface photograph showing forming failures on the periphery of an extruded ceramic formed body.

Figure 11 is a surface photograph showing the periphery of an extruded ceramic formed body without a forming failure.

### DETAILED DESCRIPTION OF THE INVENTION AND

### PREFERRED EMBODIMENTS

Specific embodiments of the present invention will now be described referring to the drawings. The present invention, however, should not be construed as being limited to these embodiments.

The die for extrusion forming of ceramics of the present invention is used for extruding ceramic formed bodies, in which the surface roughness (Ra) of the part coming in contact with extruded ceramic clay is 0.1 µm or more. The rough surface of the part of the die coming in contact with extruded ceramic clay, as large as a roughness (Ra) of 0.1 µm or more, greatly reduces forming failures such as cutting or hangnail damages of the ceramic clay in the part in which the clay comes in contact with the die surface, in extrusion forming of the ceramic clay. The surface roughness (Ra) is more preferably 0.1 µm or more and 50 µm or less, and particularly preferably 0.2 µm or more and 5.0 µm or less. The surface roughness Ra here is a value measured according to JIS B601.

In the present invention, the die for extrusion forming of ceramics preferably comprises a die member, a press board, and a back press board. The press board determines the outer peripheral configuration and size of the ceramic formed body. The surface roughness (Ra) of the part of the press board coming in contact with extruded ceramic clay is preferably 0.1 µm or more. The back press board controls the amount of the clay of the ceramic formed body and its surface roughness (Ra) in the part coming in contact with extruded ceramic clay is preferably 0.1 µm or more. This surface roughness (Ra) is more preferably 0.1 µm or more and 50 µm or less, and particularly preferably 0.2 µm or more and 5.0 µm or less.

As the method for producing a rough surface of the die, particularly, for producing the surface of the press board and back press board with a surface roughness (Ra) of 0.1 µm or more, a method of treating a matrix such as stainless steel or SKD directly using a sand blast (#10 - #800) or a method of forming a CVD or PVD layer containing one or more of TiC, TiN, and TiCN, or a complex plated layer of a nickel plated film in which a hard powder of SiC, diamond, CBN, or the like is dispersed, on the matrix or the surface of the matrix, after roughening by sandblasting the matrix, can be given.

In addition to the method of adjusting the surface roughness (Ra) sandblasting, physical vapor deposition of WC powder can produce a layer of nonuniform WC particles on the surface of the matrix or the plated layer, resulting in a surface roughness (Ra) of 0.1 µm or more.

The method for producing a rough surface on the die for extrusion forming of ceramics of the present invention is not limited to the method of sandblasting or the method of physical vapor deposition of WC particles. Any method that can produce a surface roughness (Ra) of 0.1 µm or more can be used.

In this invention, the press board part contacting the extruded ceramic clay is coated with wear resistant material, in view of a long life of the die, this material being diamond-like carbon (DLC) film, which is particularly desirable not only due to improved formability, but also excellent wear resistance.
The surface roughness (Ra) of the diamond-like carbon film is 0.1 µm or more.

In the present invention, the diamond-like carbon (DLC) film coat is a dense coating layer of which the thickness is usually 0.01-10.0 µm.

From the above description, it can be understood that the die for extrusion forming of ceramics of the present invention is suitably used for extrusion forming of a ceramic honeycomb structure body which is structurally complicated, has a thin wall area and the like, and for which high molding accuracy is demanded.

Next, the die for extrusion forming of ceramics of the present invention will be explained referring to the drawings.

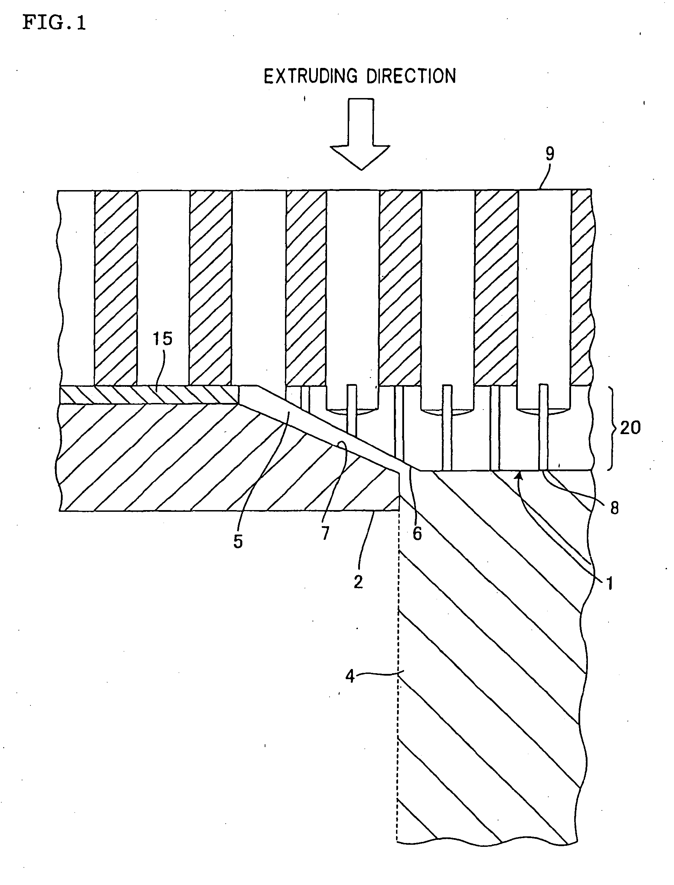

Figure 1 is a schematic cross-sectional view showing a preferred embodiment of the die for extrusion forming of a formed honeycomb ceramic body of the present invention. Figure 2 is a schematic cross-sectional view showing another preferred embodiment of the die for extrusion forming of a formed honeycomb ceramic body of the present invention.

In the die for extrusion forming of ceramics shown in Figure 1, a die member 1 has mutually communicating discharging passages 8 for extruding a formed honeycomb ceramic body and a number of charging passages 9 partially communicating with one end of the discharging passages 8 independently provided to a certain depth. A slope 6 of the periphery of a discharge section 20 having discharge passages 8 sloping in the direction of circumference is provided. On the periphery side of the die member 1 opposing the slope 6, a press board 2 defining the outer wall of a formed honeycomb ceramic body is secured via the die member 1 and a spacer 15. A space 5 is formed between the slope 6 and a surface 7 of this press board 2 opposing thereto.

In another embodiment shown in Figure 2, the die for extrusion forming of ceramics is provided with, in addition to a die member 1 and a press board 2 which defines the outer wall of the formed honeycomb ceramic body, arranged on the outer periphery of the die member 1, a back press board 3 for controlling the amount of extruded clay, similarly arranged on the outer periphery of the die member 1. Describing the structure of the back press board 3 in more detail referring to Figure 2, a slot pipe board 16 for fine adjustment of the amount of ceramic clay and a masking plate 17 formed on the outside of the slot pipe board 16 for roughly controlling the amount of ceramic clay are provided coaxially approaching each other on the ceramic clay supply side of the charging passage 9 of the die member 1. The slot pipe board 16 has through-holes 18 of which the center axes coincide with each charging passage 9. On the ceramic clay inlet side of the slot pipe board 16, another through-hole 19 is provided in the area some distance apart from the outside end of the honeycomb formed body to be extruded.

In the die for extrusion forming of ceramics shown in Figures 1 and 2, the clay extruded from the space 5 between the die member 1 and the press board 2 forms the periphery (outer wall) of a ceramic formed body 4.

In the die of the present invention, the part coming in contact with extruded ceramic clay is provided with a rough surface with a surface roughness (Ra) of 0.1 µm or more.

### EXAMPLES

Changes in the state of the outer wall of ceramic formed bodies by extrusion forming according to the surface roughness in the part coming in contact with extruded ceramic clay and the presence or absence of a DLC coat of the press board which constitutes the die for extrusion forming of ceramics were studied and compared based on the following Examples and Comparative Examples. Test Examples 2-10 are examples of the present invention.

An argillaceous clay was extruded using the die for extrusion forming of ceramics.

The clay was obtained by adding 4 wt% of methylcellulose and water to a raw material powder of talc, kaolin, and alumina and kneading the mixture using a kneader (not shown).

In the table summarizing the results obtained in the following Examples and Comparative Examples, "surface processing" indicates sand blasting of a SKD matrix press board using #80 - #120 sand for adjusting the surface roughness (Ra). The surface processing does not include DLC coating.

(Test Example 1 - reference Example)

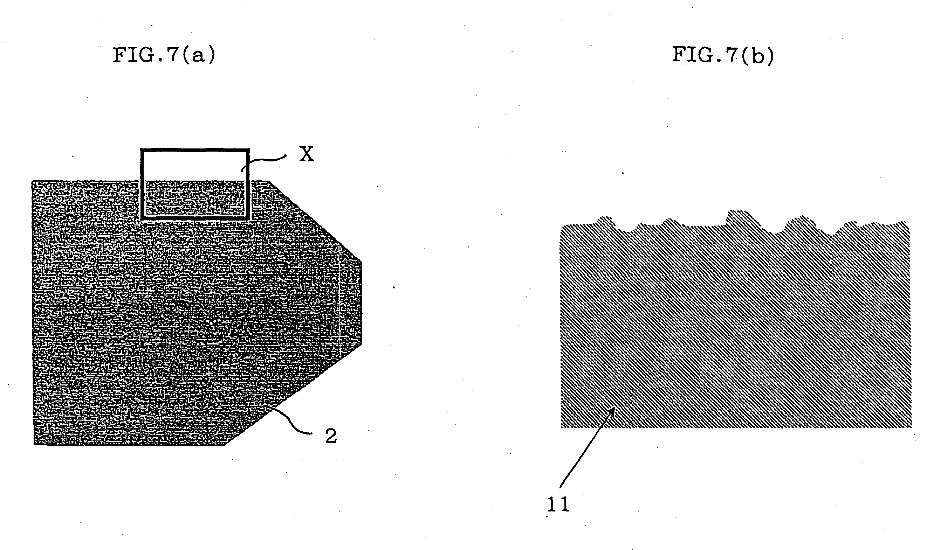

As shown in Figures 7(a) and 7(b), the surface of the SKD matrix 11 of a press board 2 was processed (surface processing). The die was secured using the press board and the above-mentioned ceramic clay was extruded. The resulting formed body was dried and evaluated. A press board with a surface roughness (Ra) of 1.8 µm was used. The results are shown in Table 1.

(Definition of forming failure rate)

The forming failure rate is defined as the percentage of defective formed bodies with an hangnail damage on the surface, when 10,000 formed bodies, each having a diameter of 100 mm and a length of 120 mm, were produced by extrusion, i.e. the number of formed bodies with an hangnail damage/10,000 formed bodies).

(Test Example 2-10)

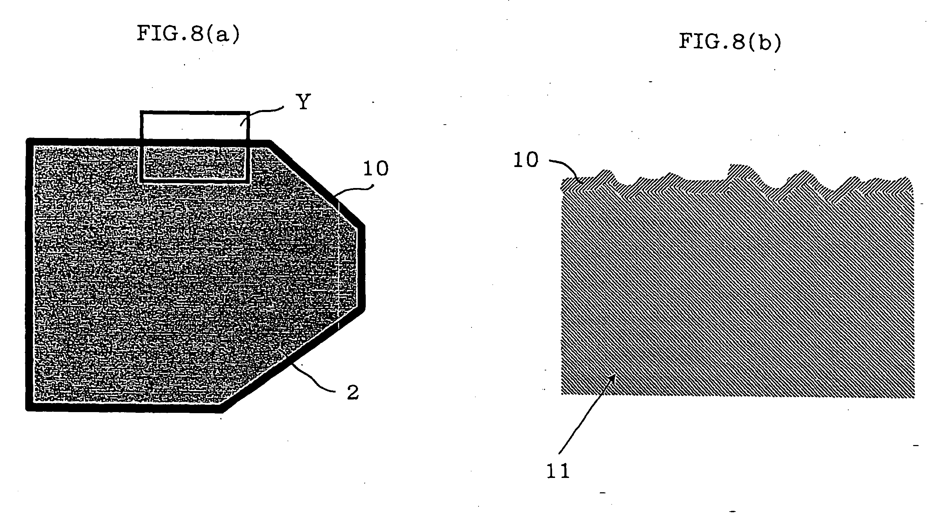

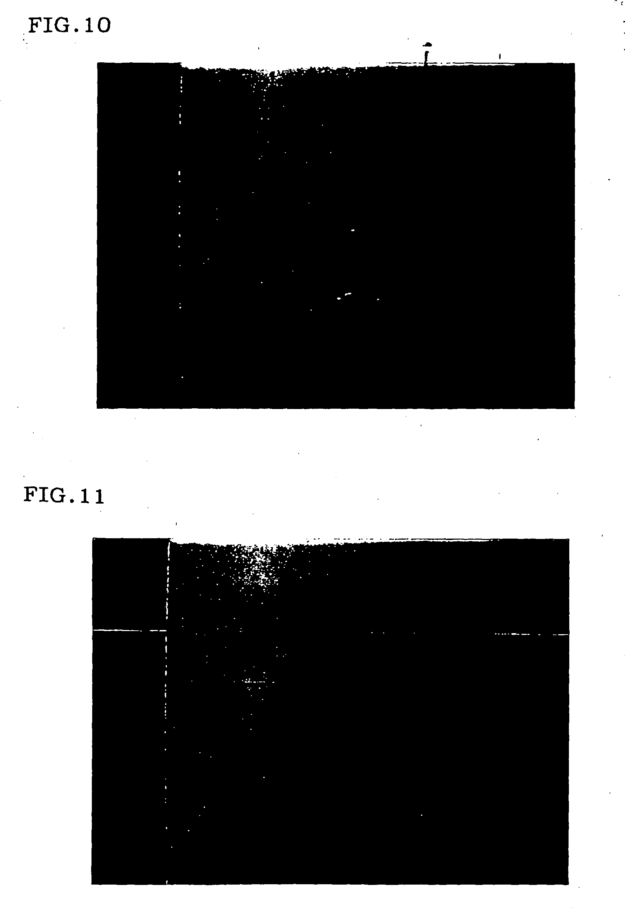

Formed bodies were prepared and evaluated in the same manner as in Test Example 1 except for applying a DLC coat 10 after the surface processing on the SKD matrix 11 of the press board 2, as shown in Figures 8(a) and 8(b). Nine samples with different surface roughness (Ra), all 0.,1 µm or more, after DLC coating were prepared and examined. The results are shown in Table 1. Figure 10 shows the state of the outer wall of the ceramic formed body by extrusion forming in Test Example 6. It can be seen the product has no hangnail damage defects.

(Comparative Example: Test Example 11)

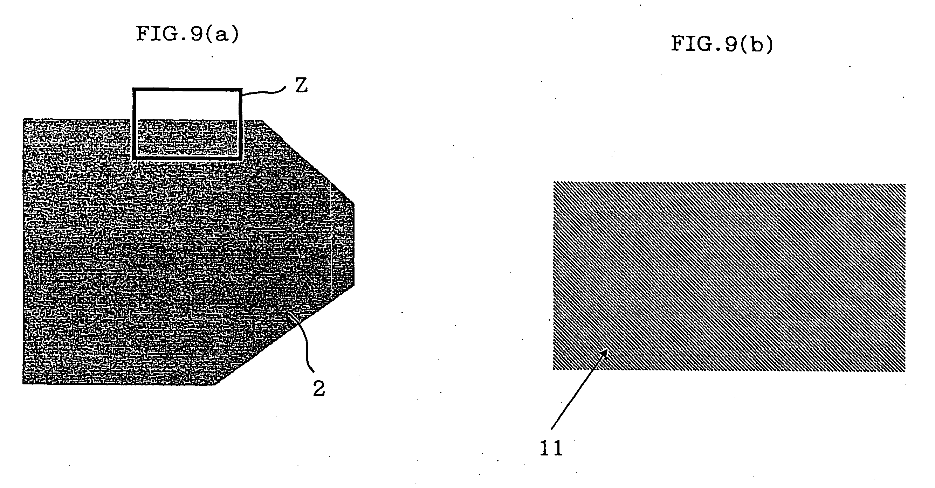

Formed bodies shown in Figures 9(a) and 9(b) were prepared and evaluated in the same manner as in Test Example 1, except for using an SKD press board 2 polished by mirror plane finishing without surface processing. A die treated by mirror plane finishing without surface processing having a surface roughness (Ra) of 0.05 µm was used. The results are shown in Table 1. Figure 11 shows the state of the outer wall of the ceramic formed body by extrusion forming in Test Example 11. It can be seen the product has defects such as a recess and hangnail damage.

As can be seen from the results shown in Table 1, Test Example 1 confirmed a remarkable decrease of defective product rate as compared with Test Example 11 which is given as a comparative example. Based on the results of these experiments, a commonly accepted belief that a smooth surface of a die for extrusion, such as a surface treated with mirror plane finishing, is preferable for improving formability, particularly, formability of an outer wall, is not necessarily true, but such a surface rather was demonstrated to become a cause of defective forming.

As is clear from the comparison of the results of Test Example 1, in which the defective forming rate is 2%, and the results of Test Examples 2-10, in which the defective forming rate is 0.5% or less, DLC coating in addition to the surface processing to make the surface roughness (Ra) 0.1 µm or more further increases the effect of reducing the defective forming percentage.

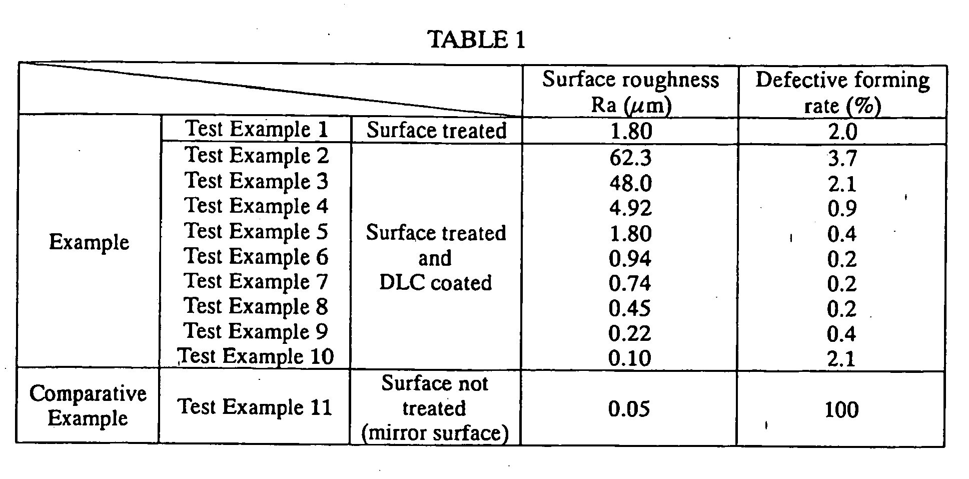

As described above, since the rate of peripheral forming defects can be significantly reduced by using the die for extrusion forming of ceramics of the present invention, the die can be suitably used for the extrusion forming of ceramic honeycomb structure and the like with a complicated configuration for which a high mold accuracy is demanded. Such a ceramic honeycomb structure can be suitably used as a catalyst carrier and the like for removing air pollutants in exhaust gas discharged from combustion engines, boilers, and the like and a filter for collecting diesel fine particles.

## Claims

1. A die for extrusion forming of ceramics for forming a honeycomb body comprising:
a die member (1) and
a press board (2) which defines the shape and size of a ceramic honeycomb body formed by the die, the press board being arranged at the outer periphery of the region of the die member shaping the ceramic body and being at the outlet side of the die,
**characterized in that**
the part of the press board coming in contact with extruded ceramic clay is coated with a diamond-like carbon film and has a surface roughness (Ra) of 0.1 µm or more.

2. The die for extrusion forming of ceramics according to claim 1, further comprising a back press board (3) which controls the amount of clay for the ceramic honeycomb body arranged in the outer periphery of the die member,
the surface roughness (Ra) of the part of the back press board coming in contact with extruded ceramic clay being 0.1 µm or more.

3. A method of extrusion forming of a honeycomb ceramic body wherein a die according to claim 1 or 2 is employed.

## Patentansprüche

1. Keramikextrusionsformdüse zum Formen eines Wabenkörpers, die Folgendes umfasst:
ein Düsenelement (1) und
eine Pressplatte (2), die die Form und Größe eines durch die Düse geformten Wabenkörpers definiert, wobei die Pressplatte am Außenumfang des Bereichs des Düsenelements angeordnet ist, das den Keramikkörper formt, und an der Auslassseite der Düse vorliegt,
**dadurch gekennzeichnet, dass**
der Teil der Pressplatte, der mit dem extrudierten Keramikton in Berührung kommt, mit einem diamantenähnlichen Kohlenstofffilm beschichtet ist und eine Oberflächenrauigkeit (Ra) von 0,1 µm oder mehr aufweist.

2. Keramikextrusionsformdüse nach Anspruch 1, die ferner eine hintere Pressplatte (3) umfasst, die die Menge an Ton für den Keramikwabenkörper steuert und am Außenumfang des Düsenelements angeordnet ist,
wobei die Oberflächenrauigkeit (Ra) des Teils der hinteren Pressplatte, der mit dem extrudierten Keramikton in Berührung kommt, 0,1 µm oder mehr beträgt.

3. Verfahren zum Extrusionsformen eines Keramikwabenkörpers, bei dem eine Düse nach Anspruch 1 oder 2 zum Einsatz kommt.

## Revendications

1. Filière de mise en forme par extrusion de céramiques pour former un corps en nid d'abeilles comprenant :
un élément de filière (1) et
une plaque de pression (2) qui définit la forme et la taille d'un corps en nid d'abeilles en céramique formé par la filière, la plaque de pression étant agencée au niveau de la périphérie extérieure de la région de l'élément de filière mettant en forme le corps en céramique et étant du côté de sortie de la filière,
**caractérisée en ce que**
la partie de la plaque de pression venant en contact avec l'argile réfractaire extrudée est revêtue d'un film de carbone de type diamant et a une rugosité de surface (Ra) de 0,1 µm ou plus.

2. Filière de mise en forme par extrusion de céramiques selon la revendication 1, comprenant en outre une plaque de pression arrière (3) qui commande la quantité d'argile pour le corps en nid d'abeilles en céramique agencée dans la périphérie extérieure de l'élément de filière,
la rugosité de surface (Ra) de la partie de la plaque de pression arrière venant en contact avec l'argile réfractaire extrudée étant de 0,1 µm ou plus.

3. Procédé de formation par extrusion d'un corps en nid d'abeilles en céramique dans lequel une filière selon la revendication 1 ou 2 est utilisée.
